# EUROPEAN PATENT SPECIFICATION

(11) **EP 0 904 826 B1**
(45) Date of publication and mention of the grant of the patent: **24.11.2004**
(21) Application number: 98307710.8
(22) Date of filing: 23.09.1998
(51) Int. Cl.: B01D 53/34, B01D 46/54, F24F 3/16

(54) **Method of removing ozone from intake air of CVD equipment**
Verfahren zur Entfernung von Ozon aus Ansaugluft einer CVD Vorrichtung
Procédé pour enlever l'ozone de l'air d'aspiration d' un dispositif CVD

(30) Priority: 30.09.1997 KR 9750374
(43) Date of publication of application: 31.03.1999
(73) Proprietor: SAMSUNG ELECTRONICS CO., LTD., Suwon-City, Kyungki-do (KR)
(72) Inventor: Yang, Chang-Jip, Suwon-City, Kyungki-Do (KR); Youk, Geun-Mok, Paldal-gu Suwon-city Kyungki-do 442-470 (KR); Cho, Chong-Hyeong, Seocho-gu Seoul 137-131 (KR); Park, Young-Kyou, Songpa-Gu, Seoul (KR)
(74) Representative: Kyle, Diana

(56) References cited:
- EP-A- 0 748 990
- DE-A- 19 721 515
- US-A- 5 626 820
- US-A- 5 752 985

## Description

The present invention relates to a method of removing ozone from intake air of CVD equipment.

Fine particles or chemicals may contaminate a highly integrated semiconductor device during fabrication, lowering quality. Particularly, in a very large-scale integrated semiconductor device such as a 1 Gb DRAM having 0.18µm line width, process trouble by fine particles or chemicals may occur in unexpected field during fabrication process. Thus, in the view of particle contaminants, careful attention is required to suppress particle contaminants, and reappraisal of conventional semiconductor fabricating equipment is required for fabricating a very large-scale integrated semiconductor device. Particularly, a process and semiconductor fabricating equipment which causes process variation when influenced by environmental factors such as fine particles and chemicals, must be thoroughly verified. General semiconductor fabricating equipment uses various types of filter in order to block particles which may be taken therein. However, most filters can remove only solid particles, i.e., particle contaminants, and not chemical contaminants. As a result, ozone (O₃), oxygen-nitrogen compounds (NOₓ), and oxygen-sulfur compounds (SOₓ) contained in air flow into semiconductor fabricating equipment via the filter, without being eliminated by the filter. The O₃, NOₓ and SOₓ cause a chemical reaction in wafer under processing, thereby deteriorating the resultant semiconductor device. There are many types of semiconductor fabricating equipment which is sensitive to chemical contaminants. However, such contamination by chemicals is especially serious in a chemical vapor deposition (CVD) equipment used in a hemispherical polysilicon grain process which is sensitive to a native oxide layer.

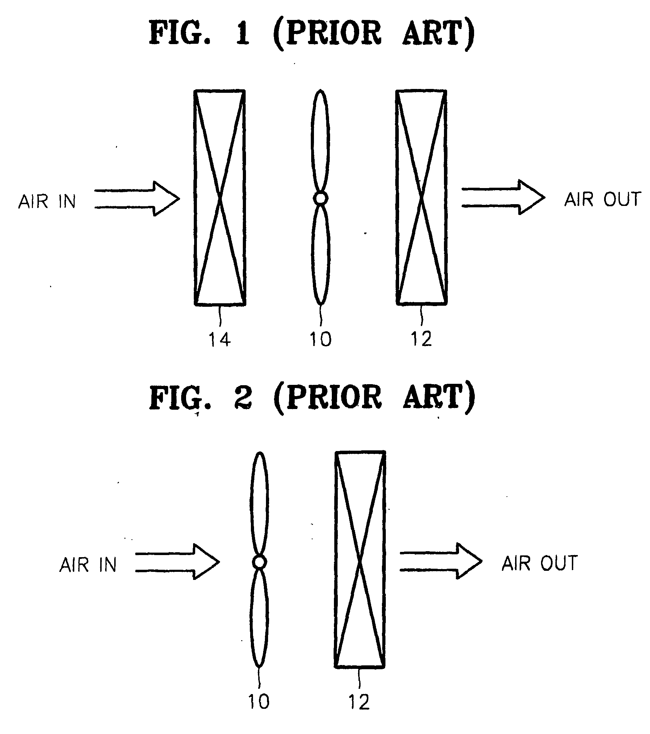

FIGs. 1 and 2 show conventional air intakes for semiconductor fabricating equipment.

FIG 1 shows an air intake apparatus which is mainly used when the air intake path is relatively short, and FIG. 2 shows an air intake apparatus which is mainly used when the air intake path is relatively long. The air intake apparatus includes a fan 10 for drawing air from the outside into the equipment, and a high efficiency particle air (HEPA) filter 12 (22) for removing particle contaminants contained in the air. That is, after drawing in air from the outside via the fan 10 (20), the particle contaminants in the air are eliminated using the HEPA filter 12 (22). Reference numeral 14 of FIG. 1 represents a pre-filter for eliminating rough particle contaminants before the fan 10.

However, since the above-described air intake apparatus for semiconductor fabricating equipment cannot remove chemical contaminants existing in the air, such as O₃, NOₓ and SOₓ, the chemicals are inflown to the equipment, thereby deteriorating the quality of a semiconductor device under process. The problem of deterioration of a semiconductor device is particularly serious in a CVD equipment used in a hemispherical polysilicon grain process which is sensitive to a native oxide layer.

US 5 626 820 describes apparatus for removing chemical contamination from air entering a clean room. The apparatus comprises a plenum upstream of a gas phase filter. Downstream of the gas phase filter there is provided a HEPA filter.

EP 748 990 describes apparatus supplying clean air to a store. Air enters the apparatus through an air intake fan and then passes through a pre-filter. Pre-filtered air posses through a hydrocarbon removing flter and then through a further filter for removing particles generated in the hydrocarbon removing filter.

According to the invention there is provided a method of removing ozone from intake air of CVD equipment, the method comprising the steps of drawing in air from outside of CVD equipment using an air intake means wherein particulate contaminants are removed from the air using a first filter; removing ozone from the drawn in air using an ozone filter comprising activated carbon; offsetting a drop in air pressure using a fan disposed between the ozone filter and a second filter; and removing particles from the air using a second filter the air intake holes of the first filter being larger than the air intake holes of the second filter.

The pre-filter has air intake holes which are larger than those of the HEPA filter, and the air intake can comprise a fan.

Examples of the present invention will now be described in detail with reference to the accompanying drawings, in which:
FIGs. 1 and 2 show conventional air intakes for semiconductor fabricating equipment;
FIGs. 3 and 4 illustrate an air intake apparatus for semiconductor fabricating equipment and a method for removing chemical contaminants using the apparatus, according to one preferred example of the present invention;
FIG 5 illustrates an air intake apparatus for semiconductor fabricating equipment and a method for removing chemical contaminants using the apparatus, used in accordance with another preferred example of the present invention; and
FIGs. 6 through 8 are graphs showing the results when the air intake apparatus use in accordance with the present invention is applied to chemical vapor deposition (CVD) equipment used in a hemispherical polysilicon grain (HSG) process.

In the following, a chemical filter includes the widest meaning and is not limited to a specific shape or structure. In the following examples, the body of the chemical filter, having air intake holes and containing activated carbon, is rectangular. However, the shape of the chemical filter's body may be modified into a circle, an ellipse or a polygon. Also, the air intake holes of the chemical filter are shaped as rounded zigzags. However, the arrangement of the air intake holes may be modified. Thus, this invention should not be construed as limited to the embodiments set forth herein.

### Example 1

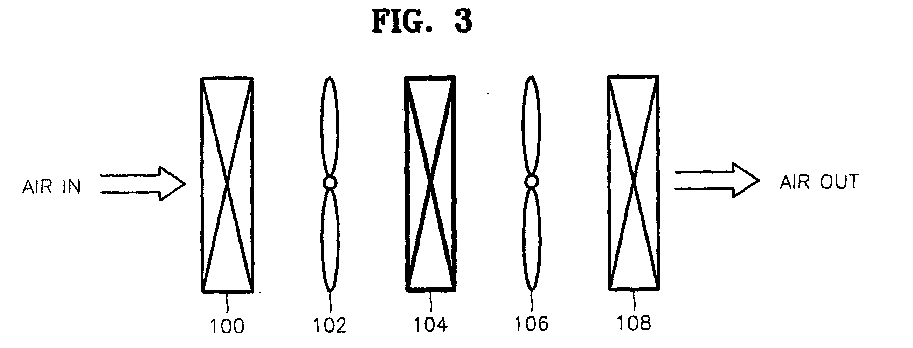

FIG. 3 is a side view of the air intake apparatus for semiconductor fabricating equipment used in accordance with the present invention, when the air intake path is long. First, particle contaminants which are relatively large are eliminated by a pre-filter 100. Then, the air is drawn into the air intake apparatus by a first fan which corresponds to an air intake means 102, for filtering. Then, chemical contaminants remaining in the air, such as ozone (O₃), are eliminated from the air by a chemical filter 104. Here, if the air intake path is long, pressure of the air inflown via the first pan as the air intake means 102 may decrease while passing through the chemical filter 104. Thus, a second fan 106 is operated in order to supplement the reduced air pressure, such that the air passed through the chemical filter 104 reaches a high efficiency particle air (HEPA) filter 108 for removing particle contaminants. The remaining particle contaminants are removed by the HEPA filter 108. Therefore, the air intake apparatus of CVD equipment according to the present invention removes chemical contaminants as well as particle contaminants from the air taken from the outside, thereby improving performance of a semiconductor device which is processed by the semiconductor fabricating equipment.

The pre-filter 100 removes particles from the air in the same manner as the HEPA filter 108. However, the size of air intake holes formed in the pre-filter 100 are larger than those formed in the HEPA filter 108.

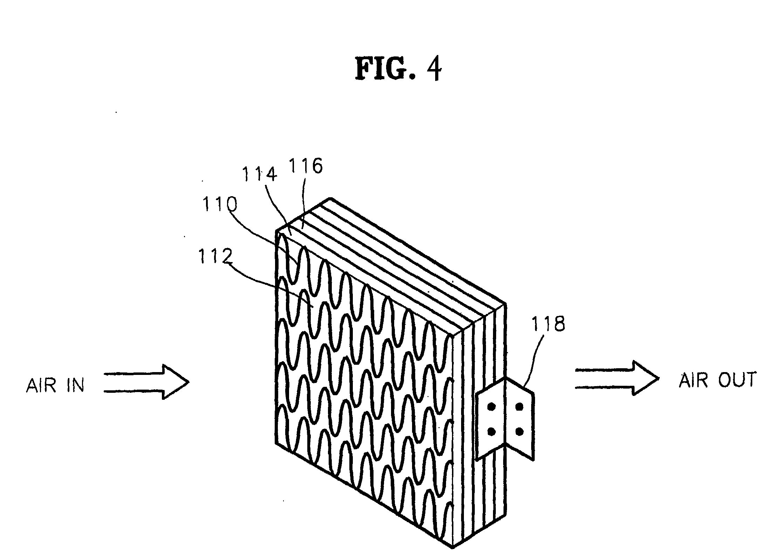

FIG. 4 is an enlarged view of the chemical filter shown in FIG. 3. In detail, the chemical filter is obtained by chemically processing to the surface of a general filter such that chemical contaminants containing in air are absorbed by a chemical reaction. The chemical filter of the present invention is for removing ozone (O₃) from the air. by using activated carbon in the surface of a body 110 thereof. Also, the chemical filter body 110 has a plurality of air intake holes 112.

Here, in an outermost layer 114 of the body 110 of the chemical filter, the air intake holes are repeatedly arranged in rounded zigzags such that the activated carbon component is spread thereover as wide as possible. Thus, chemical contaminants, such as ozone (O₃), oxygen-nitrogen compound (NOₓ) and oxygen-sulphur compound (SOₓ), passing through the air intake holes 112, are absorbed by the activated carbon, thereby producing carbon dioxide (CO₂) as the reaction product. That is, the ozone component passing through the chemical filter is removed because oxygen and carbon element produce carbon dioxide (CO₂) by a chemical reaction. Preferably, the body 110 of the chemical filter is comprised of a plurality of layers. Here, in a second layer 116 next to the outermost layer 114, air intake holes are rounded zigzags at 90°. to those of the outermost layer 114. Thus, while passing through the chemical filter, there is more chance of the oxygen contained in the chemical contaminants of the air reacting with the carbon of the activated carbon, so ozone may be effectively removed. Thus, the above chemical filter can increase its ozone removing effect by changing the structure of the chemical filter body 110 as 90° rounded zigzags in second layer 116 while an outermost layer 114 has the zigzags type body structure. Here, reference numeral 118 represents a chemical filter mounting portion used to install the chemical filter in semiconductor fabricating equipment.

Now, a method for removing chemical contaminants, using the air intake apparatus for semiconductor fabricating equipment, will be described with reference to FIGs. 3 and 4.

First, the air intake means 102 (the first fan) of FIG. 3 is operated to draw in air from the outside. Here, the pre-filter 100 which is installed at the leading end of the air intake means 102 removes comparatively large particle contaminants at first from the inflown air. Then, the air passes through the air intake holes 112 (see FIG. 4) of the chemical filter 104. Here, oxygen contained in the chemical components such as ozone (O₃), oxygen-nitrogen compounds (NOₓ) and oxygen-sulfur compounds (SOₓ), passing through the air intake holes 112, combine with the activated carbon contained in the chemical filter body 110, thereby producing carbon dioxide (CO₂). As a result, the ozone of the air is removed. If the air intake path is long, loss in air pressure occurs while passing through the chemical filter 104. However, such loss in air pressure is made up for by operating the second fan 106 between the chemical filter 104 and the HEPA filter 108. Finally, fine particle contaminants reaching the HEPA 108 by operating the second fan 106 are removed. Here, the air intake holes of the HEPA filter 108 are smaller than those of the pre-filter 100. That is, the fine particle contaminants are removed via two steps by the pre-filter 100 and the HEPA filter 108.

### Example 2

While the first example places the chemical filter after the first fan as the air intake means, the second example places the HEPA filter after the first fan and then the chemical filter after the HEPA filter.

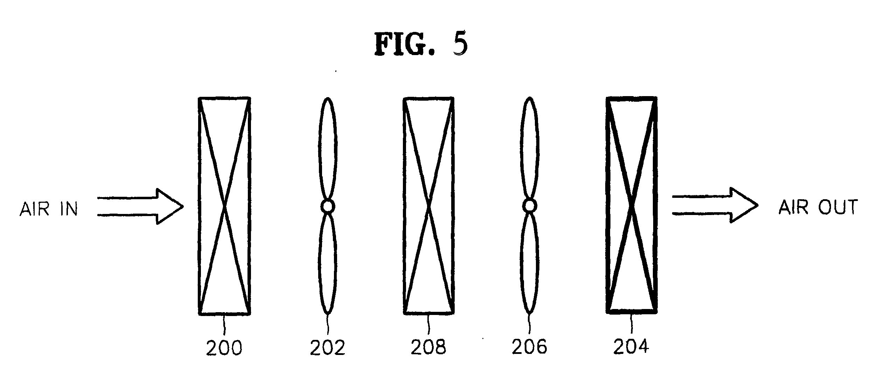

FIG. 5 is a side view of the air intake apparatus which is suitable when the air intake path is long. The air intake apparatus includes a pre-filter 200 located at the leading end of the air intake path, a first fan as an air intake means 202, a HEPA filter 208 installed directly after the air intake means 202, a second fan 206 for supplementing loss in pressure, and a chemical filter 204 installed at the end of the air intake path. The structure and the role of each unit constituting the air intake apparatus are the same as those of the first example, thus explanation thereof will be omitted.

Now a method for removing chemical contaminants using the air intake apparatus of a semiconductor fabricating equipment according to the second example of the present invention will be described with reference to FIGs. 5.

First, air is taken from the outside of the semiconductor fabricating equipment by operating the first fan as the air intake means 202 of FIG. 5. Here, the pre-filter 200 is installed at the leading of the air intake means 202 to remove comparatively large particle contaminants from the taken air. Then, fine particle contaminants are removed by the HEPA filter 208 from the inflown air. Here, if the air intake path is long. Loss in pressure occurs while passing through the HEPA filter 208, and such loss in pressure is compensated for by operating the second fan 206 installed between the HEPA filter 208 and the chemical filter 204. Finally, oxygen components of the chemical contaminants such as ozone (O₃), oxygen-nitrogen compounds (NOₓ) and oxygen-sulfur compounds (SOₓ) are combined with the activated carbon contained in the body of the chemical filter while passing through the air intake holes of the chemical filter, thereby producing carbon dioxide (CO₂) at the chemical filter 204. As a result, the ozone is removed from the air.

### Experimental Example

The HSG process is for increasing capacitance by increasing the surface area of a capacitor storage electrode in DRAM, and is adopted when a very large scale of DRAM is fabricated. The increase of the surface is achieved by forming HSGs on the surface of the storage electrode. The mechanism of forming the HSGs is as follows. First, small amorphous silicon seeds are formed on polysilicon constituting the storage electrode of a capacitor. Then, under a vacuum and at an appropriate temperature, polysilicon atoms of the storage electrode migrate to near the small amorphous silicon seeds, thereby growing the small amorphous silicon seeds into grains on the surface of the storage electrode of the capacitor.

However, if chemical contaminants such as ozone are inflown via the air intake apparatus of the CVD equipment, a native oxide (SiO₂) layer is formed on the surface of the polysilicon of the storage electrode during HSG growing process. The native oxide layer prevents the migration of the polysilicon atoms around the small amorphous silicon seeds, so that the size of the HSG is reduced, thereby lowering performance of the DRAM because of lower capacitance.

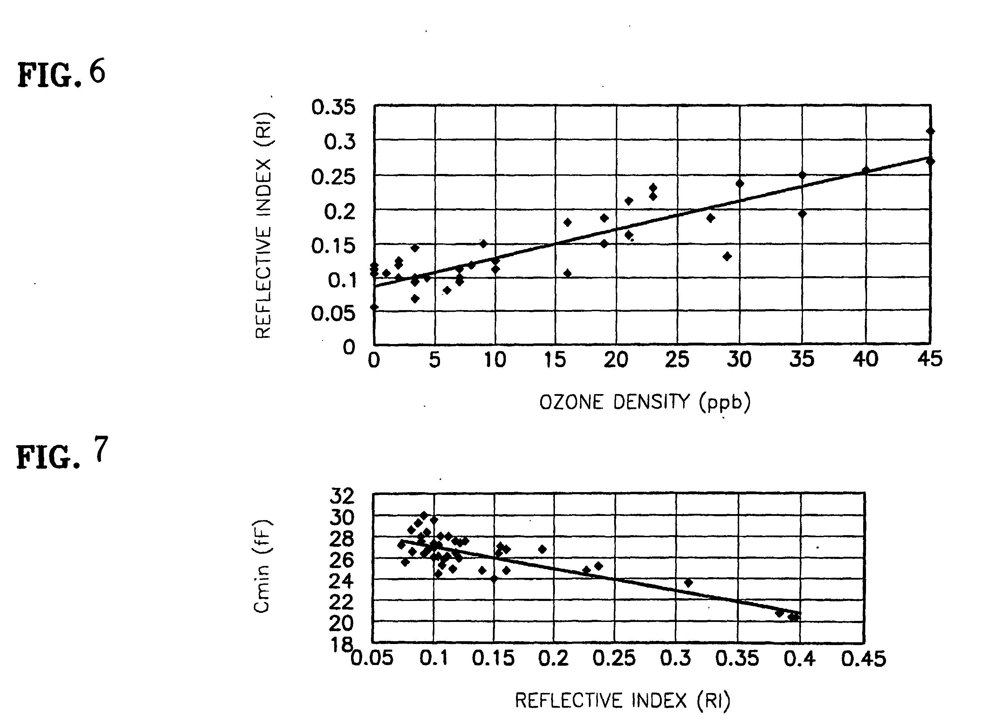

FIG. 6 is a graph showing reflective index measured at the surface of polysilicon of the storage electrode during the HSG growing process, versus ozone density within the CVD equipment. Generally, when ozone is flowed into semiconductor fabricating equipment, the native oxide layer is formed, thereby increasing reflective index. In FIG. 6, the X-axis represents ozone density (ppb) and the Y-axis represents reflective index. As can be seen from the graph, the ozone density and the reflective index have a direct proportional relationship. That is, as the ozone density increases, the reflective index increases due to the effect of the natural oxide layer formed by the ozone.

FIG. 7 is a graph showing a correlation between the reflective index at the surface of the capacitor storage electrode and the minimum capacitance (Cmin) of the capacitor, during the HSG growing process. In FIG. 7, the X-axis represents the reflective index, and the Y-axis represent the minimum capacitance (Cmin). Here, because the reflective index and the minimum capacitance (Cmin) have an inverse proportional relationship, the minimum capacitance decreases as the reflective index increases. That is, a higher reflective index prevents the growth of the HSGs, thereby causing difficulties in obtaining a higher capacitance. From the results of FIGs. 6 and7, it can be understood that the size of the HSGs of the capacitor storage electrode decreases as the ozone density increases, thereby decreasing capacitance.

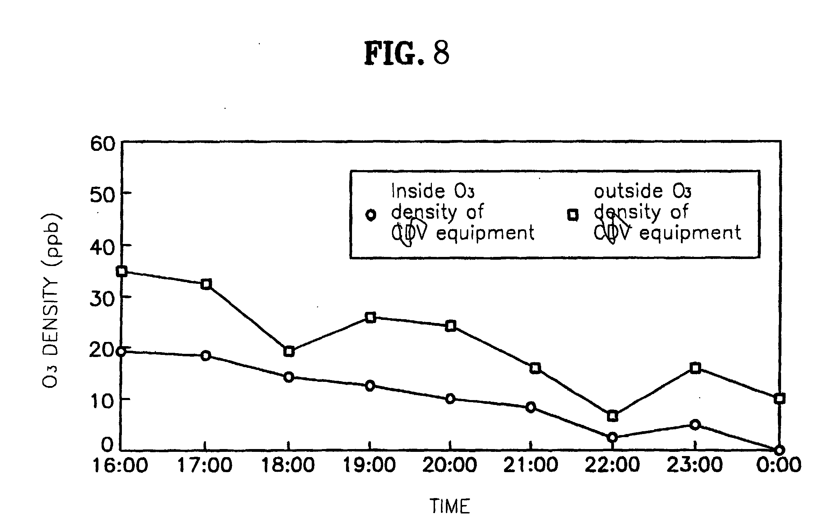

FIG. 8 is a graph showing the ozone removing capability of the air intake apparatus used in accordance with the present invention, which is installed at the top and side of the CVD equipment used for the HSG process. Here, the graph with circles (-o-o-) represents the ozone density inside the equipment, that is, the ozone density after the chemical contaminants such as ozone have been reduced by the air intake apparatus. The graph with rectangles (-□-□-) represents the ozone density outside the equipment, that is, the ozone density before the chemical and particle contaminants are filtered. Here, the X-axis represents the time at which each measurement was performed, and the Y-axis represents ozone density (ppb).

As can be seen from FIG. 8, by installing the air intake apparatus used in accordance with the present invention to the CVD equipment used for the HSG process, the ozone density inside the equipment is markedly decreased. In terms of percentage, the internal ozone density is decreased by an average of 57.3% compared with outside ozone density. Accordingly, due to the decreasing of the ozone density, the HSGs grow larger during the HSG process, thereby increasing the capacitance in a small area.

## Claims

1. A method of removing ozone from intake air of CVD equipment, the method comprising the steps of:
drawing air from outside of CVD equipment using an air intake means (102) wherein particulate contaminants are removed from the air using a first filter (100);
removing ozone from the drawn in air using an ozone filter (104) comprising activated carbon;
offsetting a drop in air pressure using a fan (106) disposed between the ozone filter (104) and a second filter (108); and
removing particles from the air using a second filter (108) the air intake holes of the first filter (100) being larger than the air intake holes of the second filter (108).

2. A method as claimed in claim 1 wherein the air intake means (102) comprises a fan.

3. A method as claimed in claim 1 or 2 wherein the second filter (108) is disposed upstream of the ozone filter (104).

## Patentansprüche

1. Verfahren zur Entfernung von Ozon aus Ansaugluft einer CVD-Vorrichtung, wobei das Verfahren die Schritte umfasst:
Ansaugen von Luft von außerhalb der CVD-Vorrichtung unter Verwendung eines Luftansaugmittels (102), worin partikelförmige Verunreinigungen aus der Luft unter Verwendung eines ersten Filters (100) entfernt werden;
Entfernen von Ozon aus der angesaugten Luft unter Verwendung eines Ozonfilters (104) mit Aktivkohle;
Ausgleichen eines Luftdruckabfalls unter Verwendung eines zwischen dem Ozonfilter (104) und einem zweiten Filter (108) angeordneten Gebläses (106); und
Entfernen von Partikeln aus der Luft unter Verwendung eines zweiten Filters (108), wobei die Luftansauglöcher des ersten Filters (100) größer sind als die Luftansauglöcher des zweiten Filters (108).

2. Verfahren nach Anspruch 1, worin das Luftansaugmittel (102) ein Gebläse umfasst.

3. Verfahren nach Anspruch 1 oder 2, worin der zweite Filter (108) vor dem Ozonfilter (104) angeordnet ist.

## Revendications

1. Procédé pour éliminer l'ozone de l'air d'admission d'un dispositif CVD, le procédé comprenant les étapes consistant à :
aspirer de l'air à partir de l'extérieur du dispositif CVD à l'aide de moyens d'admission d'air (102) dans lesquels des contaminants particulaires sont éliminés de l'air à l'aide d'un premier filtre (100) ;
éliminer l'ozone de l'air aspiré à l'aide d'un filtre à ozone (104) comprenant du charbon actif ;
compenser une chute de pression de l'air à l'aide d'un ventilateur (106) disposé entre le filtre à ozone (104) et un second filtre (108) ; et
éliminer des particules de l'air à l'aide d'un second filtre (108), les orifices d'admission d'air du premier filtre (100) étant plus importants que les orifices d'admission d'air du second filtre (108).

2. Procédé selon la revendication 1, dans lequel les moyens d'admission d'air (102) comprennent un ventilateur.

3. Procédé selon la revendication 1 ou 2, dans lequel le second filtre (108) est disposé en amont du filtre à ozone (104).
